(19) **Europäisches Patentamt / European Patent Office / Office européen des brevets**

(11) **EP 4 497 522 A1**

(12) **EUROPEAN PATENT APPLICATION**
published in accordance with Art. 153(4) EPC

(43) Date of publication:
29.01.2025 Bulletin 2025/05

(21) Application number: 23774722.5

(22) Date of filing: 16.03.2023

(51) International Patent Classification (IPC):
$B23B\ 27/14^{(2006.01)}$    $B23B\ 51/00^{(2006.01)}$
$B23C\ 5/16^{(2006.01)}$    $B23P\ 15/28^{(2006.01)}$
$C23C\ 14/06^{(2006.01)}$    $C23C\ 14/32^{(2006.01)}$

(52) Cooperative Patent Classification (CPC):
B23B 27/14; B23B 51/00; B23C 5/16; B23P 15/28;
C23C 14/06; C23C 14/32

(86) International application number:
PCT/JP2023/010248

(87) International publication number:
WO 2023/182126 (28.09.2023 Gazette 2023/39)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 22.03.2022 JP 2022045633

(71) Applicant: **Mitsubishi Materials Corporation
Tokyo 100-8117 (JP)**

(72) Inventors:
• **TAKAYAMA Shin
Tokyo 100-8117 (JP)**
• **ASANUMA Hidetoshi
Tokyo 100-8117 (JP)**

(74) Representative: **Gille Hrabal
Partnerschaftsgesellschaft mbB
Patentanwälte
Brucknerstraße 20
40593 Düsseldorf (DE)**

(54) **SURFACE COATED CUTTING TOOL**

(57) A cutting tool includes a lower layer having an average thickness At from 0.3 pm to 6.0 pm and an upper layer having an average thickness Bt from 0.1 to 3.0 pm, and $2.0 \leq At/Bt \leq 5.0$;

the lower layer includes an alternating laminate of A1α sublayers with an average thickness at and A1β sublayers with an average thickness βt, and $0.5\ nm \leq at \leq 4.0\ nm$, $0.5\ nm \leq \beta t \leq 4.0\ nm$, and $0.7 \leq \beta t/at \leq 1.3$;

the A1α sublayers each have a composition $Al_xTi_{1-x}N$ (the average $x_{avg}$ of $x$ is $0.35 \leq x_{avg} \leq 0.55$);

the A1β sublayers each have a composition $Al_yTi_{1-y}N$ (average $y_{avg}$ of $y$ is

$$0.60 \leq y_{avg} \leq 0.80);$$

$$1.2 \leq y_{avg}/x_{avg};$$

and
the upper layer has a composition $Al_aTi_{1-a-b}Si_bN$ (average values of $a_{avg}$ and $b_{avg}$ are represented by $0.35 \leq a_{avg} \leq 0.60$ and $0.00 < b_{avg} \leq 0.15$, respectively).

[Fig. 1]

## Description

### Technical Field

The present invention relates to a surface coated cutting tool (hereinafter referred to as "coated tool"). The present application claims priority based on Japanese Patent Application No. 2022-45633, filed on March 22, 2022. The entire description disclosed in the Japanese patent application is hereby incorporated by reference.

### Background Art

It is known that a coating layer is formed on a substrate made of, for example, tungsten carbide (hereinafter denoted by WC) based cemented carbide in coated tools.

Through adjustment of the composition and layer configuration of the coating layer, a proposal has been made to achieve a coated tool with even better cutting performance.

For example, PTL 1 discloses a coated tool including a coating layer that includes two sublayers $Ti_xAl_{1-x}N$ and $Ti_yAl_{1-y}N$ ($0 \leq x < 0.5$, $0.5 < y < 1$) are alternately deposited into a laminate where the overall composition of the laminate is stoichiometrically aluminum rich. This tool has excellent wear resistance and chipping resistance.

PTL 2 also discloses a coated tool including a coating layer that includes alternating first sublayers and second sublayers, each sublayer having a thickness of 2 nm or more and 100 nm or less. The first sublayers have a composition represented by $Ti_aAl_bSi_cN$ (where $0.25 \leq a \leq 0.45$, $0.55 \leq b \leq 0.75$, $0 \leq c \leq 0.1$, and $a+b+c = 1$) while the second sublayers have a composition represented by $Ti_dAl_eSi_fN$ (where $0.35 \leq d \leq 0.55$, $0.45 \leq e \leq 0.65$, $0 \leq f \leq 0.1$, and $d+e+f = 1$), and the following relations hold: $0.05 \leq d-a \leq 0.2$ and $0.05 \leq b-e \leq 0.2$. The coated tool has improved tool life.

PTL 3 discloses a coated tool including an A layer comprising carbide of W and Ti having a nanobeam diffraction pattern indexed to the crystal structure of WC, and alternating B layers and C layers on the A layer, where the A layer has a thickness of from 1 nm to 10 nm, the B layer comprises nitride or carbonitride of Al and Ti and has an Al content of 50 atomic % or more and 70 atomic % or less, and the C layer comprises nitride or carbonitride of Al and Ti and has an Al content of 70 atomic % or more, and the difference in Al content between the B layer and the C layer is 10 atomic % or more and 30 atomic % or less. The coated tool has excellent durability in cutting of stainless steel.

.

PTL 4 discloses a coated tool including a coating layer of which the outermost sublayer comprises hexagonal nitride or carbonitride consisting of at least 60% to 80% Al, at least 5% to 10% Si, and the balance being Ti in atomic percentage of metal component only. The coated tool has durability.

### Citation List

### Patent Literature

PTL 1: Japanese Unexamined Patent Application Publication No. H7-97679
PTL 2: Japanese Unexamined Patent Application Publication No. 2017-193004
PTL 3: Japanese Unexamined Patent Application Publication No. 2015-110259
PTL 4: Japanese Unexamined Patent Application Publication No. 2017-18551

## Summary of Invention

### Technical Problem

An object of the present invention, which has been accomplished in view of the circumstances and the aforementioned proposal, is to provide a cutting tool having excellent wear resistance even use in high-speed cutting of not only steel and cast iron but also stainless steel. High-speed cutting refers to a cutting process at a cutting speed that is at least 30% higher than that of normal cutting.

### Solution to Problem

The surface coated cutting tools in accordance with an embodiment of the present invention comprising a substrate and a coating layer on the substrate,

the coating layer comprising a lower layer A and an upper layer B on the lower layer A, wherein

the lower layer A has an average thickness At of 0.3 pm or more and 6.0 pm or less, and the upper layer B has an average thickness Bt of 0.1 pm or more and 3.0 pm or less, the average thicknesses satisfying the relation: $2.0 \leq At/Bt \leq 5.0$;

the lower layer A comprises an alternating laminate of $A1\alpha$ sublayers having an average thickness $\alpha t$ and $A1\beta$ sublayers having an average thickness $\beta t$, the average thicknesses satisfying the relations: $0.5$ nm $\leq \alpha t \leq 4.0$ nm, $0.5$ nm $\leq \beta t \leq 4.0$ nm, and $0.7 \leq \beta t/\alpha t \leq 1.3$;

the $A1\alpha$ sublayers each have a composition represented by $Al_xTi_{1-x}N$ (the average value $x_{avg}$ of x satisfying the relation: $0.35 \leq x_{avg} \leq 0.55$);

the $A1\beta$ sublayers each have a composition represented by $Al_yTi_{1-y}N$ (the average value $y_{avg}$ of y satisfying the relation: $0.60 \leq y_{avg} \leq 0.80$);

the average values satisfy the relation: $1.2 \leq y_{avg}/x_{avg}$:

the upper layer B has a composition represented by $Al_aTi_{1-a-b}Si_bN$ (the average value $a_{avg}$ of a and the average value $b_{avg}$ of b, respectively, satisfying the relations: $0.35 \leq a_{avg} \leq 0.60$ and $0.00 < b_{avg} \leq 0.15$).

The surface coated cutting tools of the embodiments may satisfy the following description:

The lower layer A comprises a bottom half segment A1 in contact with the substrate and a top half segment A2 in contact with the upper layer B,

the bottom half segment A1 has an average thickness A1t and the top half segment A2 has an average thickness A2t, and the average thicknesses satisfy the relations: $0.1$ pm $\leq A1t \leq 4.5$ pm, $0.2$ pm $\leq A2t \leq 4.0$ pm, and $0.5 < A1t/A2t < 3.0$,

the bottom half segment A1 comprises a laminate of the alternating $A1\alpha$ and $A1\beta$ sublayers,

the top half segment A2 comprises an alternating laminate of $A2\gamma$ sublayers having an average thickness $\gamma t$ and $A2\delta$ sublayers having an average thickness $\delta t$, the average thicknesses satisfying the relations: $1.5$ nm $\leq \gamma t \leq 8.0$ nm, $1.5$ nm $\leq \delta t \leq 8.0$ nm, $0.7 \leq \delta t/\gamma t \leq 1.3$, and $1.0 < (\gamma t+\delta t)/(\alpha t+\beta t) < 6.0$,

the $A2\gamma$ sublayers have a composition represented by $Al_zTi_{1-z}N$ (where the average value $z_{avg}$ of z satisfies the relation: $0.30 \leq z_{avg} \leq 0.50$),

the $A2\delta$ sublayers have a composition represented by $Al_wTi_{1-w}N$ (where the average value $w_{avg}$ of w satisfies the relation: $0.55 \leq w_{avg} \leq 0.75$), and

the average value $w_{avg}$, the average value $x_{avg}$, the average value $y_{avg}$, and the average value $z_{avg}$ satisfy the relations: $1.2 \leq w_{avg}/z_{avg}$, $0.02 \leq (x_{avg}-z_{avg}) \leq 0.30$, and $0.02 \leq (y_{avg}-w_{avg}) \leq 0.30$.

Advantageous Effects of the Invention

The surface coated cutting tool exhibits excellent wear resistance in use for high-speed cutting of not only steel and cast iron but also stainless steel.

**Brief Description of Drawing**

Fig. 1 is an exemplary schematic diagram of a longitudinal cross section of a coating layer of a surface coated cutting tool in accordance with one embodiment of the present invention.

Fig. 2 is an exemplary a schematic diagram of a longitudinal cross section of the coating layer of a surface coated cutting tool in accordance with another embodiment of the present invention.

**Description of Embodiments**

The inventor has performed an intensive study on the coating layer to complete a cutting tool with excellent wear resistance even use in high-speed cutting of stainless steel while guaranteeing performance in cutting of steel and cast iron. As a result, the following findings (1) to (3) were reached.

(1) A coating layer of a laminate including an AlTiN sublayer with an high Al content and another AlTiN sublayer with a low Al content, each sublayer having an average thickness of 0.5 to 4.0 nm, increases in hardness during cutting due to the decomposition of AlTiN (probably decomposition of AlTiN into TiN and AlN), and a resulting coated tool exhibits excellent wear resistance for cutting of steel and cast iron. If oxidative wear occurs in this coating layer, however, the tool does not exhibit sufficient performance in some cases. In other words, mere lamination of AlTiN sublayers with different Al contents may reduce wear resistance due to oxidative damage.

(2) Based on the results, the inventor considered provision of a TiSiN layer on the AlTiN laminate to reduce the oxidative wear in the coating layer. The TiSiN layer, however, has low oxidation resistance; hence, boundary damage propagates during a cutting process of stainless steel, for example. In addition, a large difference in lattice constants between the TiSiN layer and the AlTiN layer results in poor consistency or alignment at the interface between these two layers.

(3) Lamination of TiAlSiN layers with different Si contents instead of the lamination of AlTiN layers barely causes decomposition of TiAlSiN (the inventor estimates that TiAlSiN decomposes into TiN, AlN, and $Si_3N_4$), resulting in low wear resistance.

The inventor further has investigated and found that the aforementioned object can be achieved by providing an alternating laminate of AlTiN sublayers with two different Al contents, each with an average thickness of 0.5 to 4.0 nm, and an AlTiN layer containing Si or AlTiSiN layer, on the AlTiN sublayers.

The inventor further has found that in the case that the lower layer includes lower a bottom half segment A1 in contact with the substrate and a top half segment A2 thereon, the object of the invention can be more certainly achieved, where the bottom half segment A1 is an alternating laminate of first and second AlTiN sublayers having different Al contents and different average thicknesses, the top half segment A2 includes an alternating laminate of first and second AlTiN sublayers having different Al contents and each having an average thickness of 1.5 to 8.0 nm, and the Al content of the first and second AlTiN sublayers in the bottom half segment A1 is higher than that of the first and second AlTiN sublayers in the top half segment A2.

The coated tool in accordance with the embodiment of the present invention will now be described in more detail. Throughout the specification and the claims, the expression "L to M" indicating a numerical range is synonymous with "L or more and M or less", and includes the numerical values of the upper limit (M) and lower limit (L). In the case that unit is stated only for the upper limit (M), the upper limit (M) and lower limit (L) are in the same unit.

I. First embodiment

The coated tool in accordance with the first embodiment will now be described.

1. Coating layer

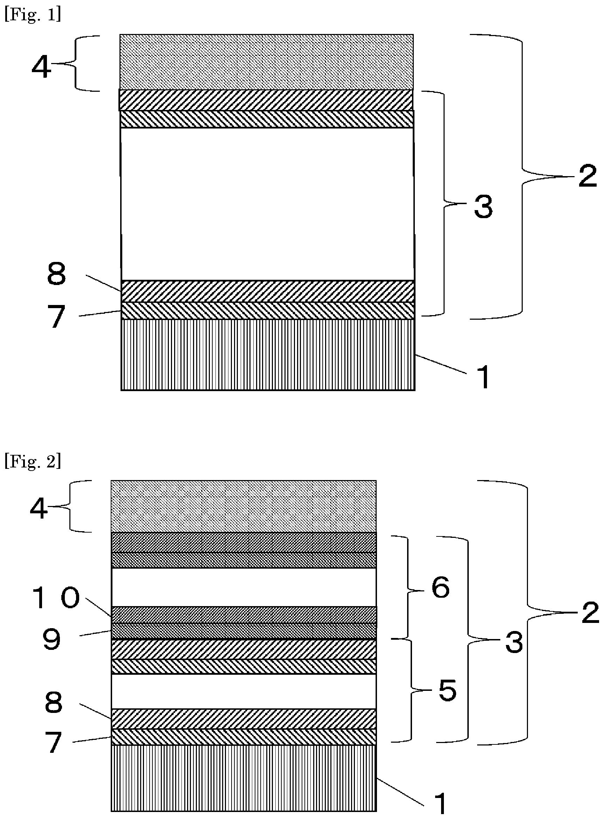

Figure 1 is a schematic view of the layer configuration of the coating layer of the coated tool in accordance with a first embodiment of the invention. The coating layer (2) has a lower layer A (3) on a substrate (1) and an upper layer B (4) on the lower layer A (3). In Figure 1, the lower layer A (3) is preferably an alternating laminate of thin sublayers , i.e., A1α sublayers (7) and A1β sublayers (8) each having an average thickness of 0.5 to 4.0 nm. In Figure 1, the white region of the lower layer A (3) also consists of an alternating laminate of A1α sublayers (7) and A1β sublayers (8). Besides these layers, the coating layer may have any other layer as will be described below.

(1) Sum of average thicknesses of lower layer A and upper layer B

The sum of the average thicknesses of the lower layer A and the upper layer B in this embodiment should be in the range of 0.4 pm to 9.0 pm for the following reasons. A thickness of less than 0.4 pm fails to demonstrate excellent wear resistance of the tool over a long period of use. A thickness exceeding 9.0 pm causes crystal grains to coarsen and thus precludes an improvement in chipping resistance. The sum of the average thickness is more preferably in the range of 0.8 pm to 6.0 pm.

(2) Average thickness of each of lower layer A and upper layer B

In preferred embodiments, the average thickness At of the lower layer A is in the range of 0.3 pm to 6.0 pm while the average thickness Bt of the upper layer B is in the range of 0.1 pm to 3.0 pm, and these average thicknesses satisfy the relation: $2.0 \leq At/Bt \leq 5.0$, for the following reasons: An average thickness At of the lower layer A and an average thickness Bt of the upper layer B within these ranges cause oxidation damage of the coating layer to be suppressed during cutting and wear resistance to be improved due to the decomposition of TiAlN into TiN and AlN in the lower layer A.

In more preferred embodiments, the average thickness At of the lower layer A is in the range of 0.6 pm to 4.0 pm while the average thickness Bt of the upper layer B is in the range of 0.2 pm to 2.0 pm. More preferably, the following relation holds: $2.3 \leq At/Bt \leq 3.5$.

An average thickness Bt of the upper layer B lower than the average thickness At of the lower layer A causes AlTiN in the lower layer A to decompose (AlTiN decomposes into TiN and AlN) during cutting, resulting in an increase in hardness and an improvement in wear resistance of the coating layer.

(3) Configuration of lower layer A

The lower layer A is an alternating laminate of A1$\alpha$ and A1$\beta$ sublayers. The average thicknesses $\alpha t$ of the A1$\alpha$ sublayers and the average thickness $\beta t$ of the A1$\beta$ sublayers hold the following relations: $0.5\,nm \leq \alpha t \leq 4.0\,nm$, $0.5\,nm \leq \beta t \leq 4.0\,nm$, and $0.7 \leq \beta t/\alpha t \leq 1.3$. It is more preferable to satisfy $0.8\,nm \leq \alpha t \leq 3.5\,nm$, $0.8\,nm \leq \beta t \leq 3.5\,nm$, and $0.8 \leq \beta t/\alpha t \leq 1.2$.
The aforementioned object can be achieved in the case that these relations on the average thicknesses are satisfied.

(3-1) Numbers of A1$\alpha$ and A1$\beta$ sublayers

The number m of A1$\alpha$ sublayers and the number n of A1$\beta$ sublayers satisfy $|\,m-n\,| \leq 1$ where m+n may be any number, in particular, preferably 50 to 2001 for the following reasons: A number of less than 50 fails to prevent propagation of cracking sufficiently during cutting operations, resulting in a decrease in chipping resistance. A number exceeding 2001 causes finer crystal grains to be formed due to an increased number of sublayers in the lower layer A, resulting in a decrease in wear resistance. The total number m+n is preferably in the range of 100 to 1001.
The A1$\alpha$ and A1$\beta$ sublayers are alternately laminated, and either one of which may be disposed adjacent to the substrate or on the surface of the tool.

(3-2) Compositions of A1$\alpha$ and A2a sublayers

In preferred embodiments, the A1$\alpha$ sublayers of the lower layer each have a composition represented by $Al_xTi_{1-x}N$ (where the average value $x_{avg}$ of x satisfy the relation $0.35 \leq x_{avg} \leq 0.55$), the A2a sublayers of the lower layer each has a composition represented by $Al_yTi_{1-y}N$ (the average value $y_{avg}$ of y satisfy the relation $0.60 \leq y_{avg} \leq 0.80$), and the relation $1.2 \leq y_{avg}/x_{avg}$ holds.
The compositions of the A1$\alpha$ and A2a sublayers within these ranges improve wear resistance, presumably due to the decomposition of AlTiN into TiN and AlN during cutting operations.
Although AlTiN, which constitutes the lower layer, is produced such that the ratio of (AlTi) to N is 1:1 by the processes described below, the ratio may unavoidably not be 1:1. This is also true for the other nitrides described below.

(4) Composition of upper layer B

The upper layer B should preferably have a composition represented by $Al_aTi_{1-a-b}Si_bN$ (where the average values $a_{avg}$ of a and $b_{avg}$ of b satisfy the relations: $0.35 \leq a_{avg} \leq 0.60$ and $0.00 < b_{avg} \leq 0.15$, respectively).
A composition of the upper layer B within the above range contributes to improvements in oxidation resistance and wear resistance.
A composition outside this range leads to decreases in oxidation resistance and wear resistance, presumably due to the precipitation of the AlN phase having a hexagonal crystal structure.

(5) Other layers

(5-1) Layer that may be intentionally deposited

An outermost layer and an underlying layer, described below, may be intentionally deposited.

(5-1-1) Outermost layer

An outermost layer may be optionally disposed on the upper layer B. An example of the outermost layer to be disposed is a TiN layer (the atomic ratio of Ti and N in the TiN layer is not limited to stoichiometric one).
Since the TiN layer itself has a golden color tone and can be used, for example, as an identification layer to determine whether the coated tool has not been used or has been used by a change of the color tone. The average thickness of the TiN identification layer may be, for example, 0.1 to 1.0 pm.

(5-1-2) Underlying layer

An underlying layer may be optionally disposed between the lower layer A and the substrate.

Examples of the underlying layer include layers of Ti compounds, such as TiC, TiN, TiCN, and TiCNO, and AlTiN layers, with an average thickness of 0.1 to 2.0 pm. An average thickness within this range causes the adhesion between the lower layer A and the substrate to further improve.

(5-2) Layers that are deposited unintentionally (layers that may occur unavoidably)

In this embodiment, the underlying layer, the lower layer A (Ala and A1β sublayers), the upper layer B, and the outermost layer are deposited in contact with each other such that no additional layers are formed. However unintended changes in pressure or temperature in the deposition system may occur during switching of the type of layer to be deposited, and unintended layers different from these layers may be formed.

3. Substrate

(1) Material

The substrate in this embodiment may be composed of any known material that can achieve the aforementioned object. Examples of such a material includes WC-based cemented carbides (containing Co in addition to WC, and also containing carbides or carbinitrides of Ti, Ta, and Nb), cermets (mainly composed of TiC, TiN, and TiCN), ceramics (titanium carbide, silicon carbide, silicon nitride, aluminum nitride, and aluminum oxide), cBN sintered compacts, and diamond sintered compacts.

(2) Shape

The substrate may have any shape suitable for cutting tools without restrictions. Examples of the shape include shapes of inserts and shapes of drills.

II. Second embodiment

The second embodiment will now be described. The description duplicating the description of the first embodiment is omitted.

1. Coating layer

Figure 2 schematically shows a layer configuration of the coating layer of the coated tool of the second embodiment. The coating layer (2) includes a lower layer A (3) on the substrate (1) and an upper layer B (4) on the lower layer A (3). The lower layer A (3) is a laminate of a bottom half segment A1 (5) and a top half segment A2 (6). In Figure 2, the bottom half segment A1 (5) has the same configuration as in the first embodiment, and the top half segment A2 (6) includes thin alternating sublayers having an average thickness of 1.5 to 8.0 nm. In other words, the bottom half segment A1 (5) includes an alternating laminate of A1α sublayers (7) and A1β sublayers (8) and the top half segment A2 (6) includes an alternating laminate of A2$_Y$ sublayers (9) and A2δ sublayers (10). It is noted that, in Figure 2, the white regions of the bottom half segment A1 (5) and the top half segment A2 (6) also includes alternating laminates of A1α sublayers (7) and A1β sublayers (8), and A2y sublayers (9) and A2δ sublayers (10), respectively.

The coating layer may include any other layer as described below, as in the first embodiment,

(1) Sum of average thicknesses of lower layer A and upper layer B

In the second embodiment, the sum of the average thickness of the lower layer A and the average thickness of the upper layer B should be preferably within the same range as in the first embodiment (the more preferred range is also the same).

(2) Average thickness of each of lower layer A and upper layer B

In the second embodiment, the average thickness of the lower layer A and the average thickness of the upper layer B are each preferably with in the same range as in the first embodiment (the more preferred range is also the same).

(3) Configuration of lower layer A

In the second embodiment, the lower layer A includes the bottom half segment A1 and the top half segment A2.

The average thickness A1t of the bottom half segment A1 and the average thickness A2t of the top half segment A2 should preferably satisfy the relations: 0.1 pm ≤ A1t ≤ 4.5 pm, 0.2 pm ≤ A2t ≤ 4.0 pm, and 0.5 ≤ A1t/A2t ≤ 3.0. Within this relation, the aforementioned object is achieved.

The bottom half segment A1 and the upper half segment A2 will be described in detail below.

(3-1) Bottom half segment A1

The bottom half segment A1 includes an alternating laminate of A1$\alpha$ sublayers and A2a sublayers, like the lower layer A of the first embodiment, and should satisfy the average thickness, the relations on the average thickness, the composition, and the relation on the composition, described in the first embodiment.

(3-2) Top half segment A2

The top half segment A2 includes an alternating laminate of A2y sublayers and A2$\delta$ sublayers. Preferably, the average thickness yt of the A2y sublayers and the average thickness $\delta$t of the A2$\delta$ sublayers satisfy the following relations:

$$1.5 \text{ nm} \leq \gamma t \leq 8.0 \text{ nm}, \ 1.5 \text{ nm} \leq \delta t \leq 8.0 \text{ nm}, \text{ and } 0.7 \leq \delta t/\gamma t \leq 1.3,$$

and satisfy the following relation:

$$1.0 < (\gamma t + \delta t)/(\alpha t + \beta t) \leq 6.0$$

on the respective average thicknesses of the A1$\alpha$ and A2a sublayers of the bottom half segment A1.

Within these relations, the aforementioned object is achieved. It is more preferable that the ratio $(\gamma t + \delta t)/(\alpha t + \beta t)$ be within $1.2 \leq (\gamma t + \delta t)/(\alpha t + \beta t) \leq 3.0$.

(3-2) Compositions of A2$_\gamma$ and A2$\delta$ sublayers

Preferably, the A2$_\gamma$ sublayer has a composition represented by $Al_zTi_{1-z}N$ (where the average value $z_{avg}$ of z satisfies the relation: $0.30 \leq z_{avg} \leq 0.50$), the A2$\delta$ sublayer has a composition represented by $Al_wTi_{1-w}N$ (where the average value $w_{avg}$ of w satisfies the relation: $0.55 \leq w_{avg} \leq 0.75$), and the relation: $1.2 \leq w_{avg}/z_{avg}$ holds.

Preferably the compositions of the A1$\alpha$ and A2$\alpha$ sublayers and the compositions of the A2$_\gamma$ and A2$\delta$ satisfy the relations:

$$0.02 \leq (x_{avg} - z_{avg}) \leq 0.30 \text{ and } 0.02 \leq (y_{avg} - w_{avg}) \leq 0.30.$$

The compositions of the A1$\alpha$, A2a, A2y, and A2$\delta$ sublayers within these ranges lead to an improvement in wear resistance for the following reasons: In the compositions within these ranges, a lower layer A having higher Al content can be formed and AlTiN probably decomposes into TiN and AlN during cutting operations. In compositions deviated from these ranges, the difference in Al content between the bottom half segment A1 and the top half segment A2 is too small to achieve sufficient decomposition. Thus, the reduction in strain by the lower layer A1 is not sufficient and the hexagonal AlN phase is precipitated, resulting in a decrease in the wear resistance of the coating layer.

(4) Average thicknesses and numbers of A1$\alpha$, A1$\beta$, A2y, and A2$\delta$ sublayers

Preferably, the A1$\alpha$ and A1$\beta$ sublayers in the bottom half segment A1 each have an average thickness in the range of 0.5 to 4.0 nm, and the A2$_\gamma$ and A2$\delta$ sublayers in the top half segment A2 each have an average thickness in the range of 1.5 to 8.0 nm. Preferably the number p of A1$\alpha$ layers and the number q of A1$\beta$ sublayers in the bottom half segment A1, and the number r of A2$_\gamma$ sublayers and the number s of A2$\delta$ sublayers in the top half segment A2 satisfy the relations: | p-q | ≤ 1 and | r-s | ≤ 1, and p+q is within the range from 50 to 901 and r+s is within the range from 20 to 551, although p+q and r+s may be deviated from these ranges. A sum p+q of less than 50 and a sum r+s of less than 20 may fail to prevent propagation of cracking occurring during cutting operations, resulting in a decrease in chipping resistance. A sum p+q of greater than 901 and a sum r+s of greater than 551 lead to an increased repeated number, and may result formation of finer grains in the bottom half A and thus a reduction wear resistance. In more preferred embodiments, the sum p+q is within the range from 100 to 451 and the sum r+s is within the range from 50 to 180.

The A1$\alpha$ and A1$\beta$ sublayers and the A2$_\gamma$ and A2$\delta$ sublayers may be alternately laminated. Either of the alternating A1$\alpha$ and A1$\beta$ sublayers may be disposed adjacent to the substrate and the top half segment A2. Either of the

alternating $A2_\gamma$ and $A2\delta$ sublayers may be disposed adjacent to the bottom half segment A2 and the tool surface.

### 3. Upper layer

The upper layer is the same as described in the first embodiment.

### 4. Other layers

The outermost layer and the underlying layer are the same as described in the first embodiment.

On the layers that are deposited unintentionally (layers that may occur unavoidably), the description is the same as that in the first embodiment except that the lower layer A (Ala and A1β sublayers) is replaced with the bottom half segment A1 (Ala and A1β sublayers) and the top half segment A2 (A2y and A2δ sublayers).

### 5. Substrate

The material and shape of the substrate may be the same as in the first embodiment.

### III. Measurement

#### 1. Average composition and average thickness on lower layer A, upper layer B, and other layers

The average thicknesses of the lower layer A, bottom half segment A1, top half segment A2, upper layer B, and other layers constituting the coated layer are measured with a scanning electron microscope (SEM), an energy dispersive X-ray spectrometer (EDS) attached to a transmission electron microscope (TEM), where a longitudinal section (a cross-section perpendicular to the flat surface, ignoring minute irregularities on the surface of the substrate for an insert; or a cross section perpendicular to the axis for an axial tool such as a drill) is observed to differentiate each layer and determine its average thickness. The average composition in each layer was determined by analysis of five TEM-EDS lines across the thickness.

The longitudinal section is observed, the interface between the substrate and the lower layer A (or bottom half segment A1) is determined by elemental mapping, and the average straight line of the roughness curve of the interface is arithmetically determined and defined as the surface of the substrate.

#### 2. Average thickness on A1α, A1β, A2y, and A2δ sublayers

The coating layer including at least 10, preferably at least 50 of these sublayers was scanned over a scanning length, and the respective intermediate values between the adjacent maxima and minima of the intensities of the Ti element in the EDS spectrum were calculated. Positions corresponding to the intermediate values were determined on the line segment of the line scanning. First distances were determined between adjacent positions including maxima to be averaged. Similarly, second distances were determined between adjacent positions including minima to be averaged. The average thickness of each layer was determined from the average of the first distances or the second distances.

### IV. Production

The coating layers of the coated tools of the first and second embodiments may be produced, for example, with an arc ion plating (AIP) system. AlTi targets having compositions corresponding to those of the bottom half segment A1 and top half segment A2 of the lower layer A and an AlTiSi target having a composition corresponding to that of the upper layer B are used for deposition of these (sub)layers.

The above description includes features that are described in the following Appendices:

(Appendix 1)

A surface coated cutting tool comprising a substrate and a coating layer on the substrate,

the coating layer comprising a lower layer A and an upper layer B on the lower layer A, wherein
the lower layer A has an average thickness At of 0.3 pm or more and 6.0 pm or less, and the upper layer B has an average thickness Bt of 0.1 pm or more and 3.0 pm or less, the average thicknesses satisfying the relation: $2.0 \leq At/Bt \leq 5.0$;
the lower layer A comprises an alternating laminate of A1α sublayers having an average thickness at and A1β sublayers having an average thickness $\beta t$, the average thicknesses satisfying the relations: $0.5\ nm \le at \le 4.0\ nm$, $0.5\ nm \le \beta t \le 4.0\ nm$, and $0.7 \le \beta t/at \le 1.3$;

the A1$\alpha$ sublayers each have a composition represented by $Al_xTi_{1-x}N$ (the average value $x_{avg}$ of x satisfying the relation: $0.35 \le x_{avg} \le 0.55$);

the A1$\beta$ sublayers each have a composition represented by $Al_yTi_{1-y}N$ (the average value $y_{avg}$ of y satisfying the relation: $0.60 \le y_{avg} \le 0.80$);

the average values satisfy the relation: $1.2 \le y_{avg}/x_{avg}$; and

the upper layer B has a composition represented by $Al_aTi_{1-a-b}Si_bN$ (the average value $a_{avg}$ of a and the average value $b_{avg}$ of b, respectively, satisfying the relations: $0.35 \le a_{avg} \le 0.60$ and $0.00 < b_{avg} \le 0.15$).

(Appendix 2)

The surface coated cutting tool as described in Appendix 1, wherein

the lower layer A comprises a bottom half segment A1 in contact with the substrate and a top half segment A2 in contact with the upper layer B,

the bottom half segment A1 has an average thickness A1t and the top half segment A2 has an average thickness A2t, and the average thicknesses satisfy the relations: $0.1\ pm \le A1t \le 4.5\ pm$, $0.2\ pm \le A2t \le 4.0\ pm$, and $0.5 \le A1t/A2t \le 3.0$,

the bottom half segment A1 comprises a laminate of the alternating A1$\alpha$ and A1$\beta$ sublayers,

the top half segment A2 comprises an alternating laminate of A2$\gamma$ sublayers having an average thickness $\gamma t$ and A2$\delta$ sublayers having an average thickness $\delta t$, the average thicknesses satisfying the relations: $1.5\ nm \le \gamma t \le 8.0\ nm$, $1.5\ nm \le \delta t \le 8.0\ nm$, $0.7 \le \delta t/\gamma t \le 1.3$, and $1.0 < (\gamma t+\delta t)/(\alpha t+\beta t) \le 6.0$,

the A2$\gamma$ sublayers have a composition represented by $Al_zTi_{1-z}N$ (where the average value $z_{avg}$ of z satisfies the relation: $0.30 \le z_{avg} \le 0.50$),

the A2$\delta$ sublayers each have a composition represented by $Al_wTi_{1-w}N$ (where the average value $w_{avg}$ of w satisfies the relation: $0.55 \le w_{avg} \le 0.75$), and

the average value $z_{avg}$ and the average value $w_{avg}$ satisfy the relations: $1.2 \le w_{avg}/z_{avg}$, $0.02 \le (x_{avg}-z_{avg}) \le 0.30$, and $0.02 \le (y_{avg}-w_{avg}) \le 0.30$.

(Appendix 3)

The surface coated cutting tool as described in Appendix 1 or 2, further comprising an outermost layer disposed on the upper layer B.

(Appendix 4)

The surface coated cutting tool as described in any of Appendices 1 to 3, further comprising an underlying layer disposed between the lower layer A and the substrate.

Examples

Examples will now be described.

Coated tools of the present invention described herein have a shape of an insert and their substrates are made of WC-based cemented carbide. The substrate may be made of any of the aforementioned materials. The coated tools may have other shapes, such as drills and end mills as described above.

Co raw powder, TiC raw powder, VC raw powder, TaC raw powder, NbC raw powder, $Cr_3C_2$ raw powder, and WC raw powder were prepared. These raw powders were blended in the formulation shown in Table 1, and then wax was added and wet-mixed in a ball mill for 72 hours, dried under reduced pressure, and compacted under 100 MPa. These green compacts were sintered at 1400°C for 1 hour under a vacuum atmosphere of 6 Pa, and then machined into given dimensions to produce Substrates 1 to 3 made of WC-base cemented carbide with a shape of an insert in accordance with the ANSI standard SEEN42AFTN1.

Substrates 1 to 3 were ultrasonically cleaned in acetone and were then dried. Substrates 1 to 3 were mounted along the outer circumference at a predetermined distance radially from the central axis on the turn table in an AIP system. A target of a predetermined composition was placed as a cathode (evaporation source).

The inside of the AIP system was evacuated to maintain a vacuum of 0.1 Pa or less while the inside of the system was heated to 600°C with a heater; and then a DC bias voltage of -1000 V was applied to the substrate rotating on the turn table, and a 100 A current was applied between the cathode and the anode for bombardment treatment of the surface of the substrate.

<Examples corresponding to first embodiment>

The AIP system was maintained at a nitrogen atmosphere (reaction gas) with a partial pressure of 2.6 to 7.5 Pa shown in Table 2 and at a furnace temperature also shown in Table 2. A DC voltage of -40 to -125 V as shown in Table 2 was applied to the substrate spinning on the turn table, while a current of 125 to 210 A was applied between the AlTi alloy electrode for forming the lower layer A (Ala sublayers and A1β sublayers) and the anode to generate arc discharge. A1α and A1β sublayers of predetermined thicknesses were thereby formed.

The deposition of the A1α and A1β sublayers was repeated a predetermined number of times to form a predetermined number of sublayers of the A layer.

. In a nitrogen atmosphere with a partial pressure of 0.4 to 0.6 Pa as shown in Table 2, a DC voltage of -40 to -120 V was applied to the substrate while a current of 120 to 220 A as shown in Table 2 was applied between the AlTiSi alloy for upper layer B and the anode to generate arc discharge to form an upper layer B having a predetermined thickness. Coated tools (hereinafter called "Examples") 1 to 9 were thereby produced.

<Example corresponding to second embodiment>

The AIP system was maintained at an atmosphere of nitrogen reaction gas with a partial pressure of 1.0 to 8.2 Pa shown in Table 4 and at a furnace temperature also shown in Table 4. A DC voltage of -30 to -120 V as shown in Table 2 was applied to the substrate spinning on the turn table, while a current of 100 to 230 A was applied between the AlTi alloy electrode for forming the bottom half segment A1 (Ala and A1β sublayers) and the anode to generate arc discharge. A1α and A1β sublayers of predetermined thicknesses were thereby formed.

The deposition of the A1α and A1β layers was repeated a predetermined number of times, to form a predetermined number of sublayers in the bottom half segment A1.

A DC voltage of -60 to -135 V was applied in a nitrogen atmosphere with a partial pressure of 3.2 to 7.5 Pa as shown in Table 4, and a current of 115 to 250 A was applied between the AlTi alloy electrode for forming the top half segment A2 (A2γ sublayers and A2δ sublayers) and the anode to generate arc electrical discharge. The A2$_\gamma$ and A2δ sublayers with a predetermined thickness were thereby formed.

The deposition of the A2$_\gamma$ and A2δ sublayers was repeated a predetermined number of times to form a predetermined number of sublayers in the top half segment A2.

In a nitrogen atmosphere with a partial pressure of 2.5 to 7.7 Pa as shown in Table 4, a DC voltage of -45 to -180 V as shown in Table 2 was applied to the substrate, and a current of 125 to 200 A was applied between the AiTiSi alloy for forming upper layer B and the anode electrode to generate arc discharge to form an upper layer B having a predetermined thickness. Coated tools of Examples 11 to 10 were thereby produced.

In some cases corresponding to the first and second embodiments, the AIP system was maintained at an atmosphere of nitrogen reaction gas with a partial pressure of 0.5 to 9.0 Pa and at a furnace temperature of 300 to 600°C. A DC voltage of -20 to -500 V was applied to the substrate spinning on the turn table while a current of 50 to 250 A was applied between the Ti electrode for the outermost layer and the anode to generate arc discharge. A TiN outermost layer with a predetermined thickness was thereby deposited (the conditions for deposition of the outermost layer are shown in Table 6). These examples are shown in Tables 7 and 8.

For comparison, in the same deposition system as described above, coating layers were deposited on Substrates 1 to 3 in accordance with the conditions shown in Table 3 for the comparative examples corresponding to the first embodiment and in Table 5 for the comparative examples corresponding to the second embodiment. Coated tools (hereinafter called "Comparative Examples") 1 to 9 in Table 7 and coated tools 11 to 19 in Table 8 were thereby fabricated.

In some comparative examples corresponding to the first and second embodiments, the outermost TiN layer was deposited as in Examples.

Longitudinal sections of the coating layers perpendicular to the surfaces of the substrates of Examples 1 to 9, 11 to 19 and Comparative Examples 1 to 9, 11 to 19 prepared as described above were observed by scanning electron microscopy (SEM), transmission electron microscopy (TEM), and energy dispersive X-ray spectroscopy (EDS), where the field of view was determined so as to include the entire thickness of the coating layer within a width of 10 pm in a direction parallel to the surface of the substrate. The average thickness and the average composition of the coating layer were thereby determined.

Specifically, thicknesses of the lower layer and the upper layer were determined at five points at a magnification of 5000 of the observed longitudinal cross section and the results were averaged to determine the average thickness of the lower layer A and the upper layer B. If the average thickness of the lower layer A or upper layer B is 1 pm or less, the longitudinal cross section was observed at five points at a magnification of 10,000 and the results were averaged to determine the average thickness. The average thickness of the individual alternating sublayers and the average content of each component in each layer were measured by the procedure described above.

[Table 1]

| Substrate | Composition (mass%) | | | | | | |
|---|---|---|---|---|---|---|---|
| | Co | TiC | VC | TaC | NbC | $Cr_3C_2$ | WC |
| 1 | 7.0 | 0.0 | 1.5 | 0.0 | 1.5 | 0.0 | Balance |
| 2 | 12.0 | 0. 0 | 2.0 | 0.0 | 0.0 | 0.5 | Balance |
| 3 | 10.0 | 1.0 | 0.0 | 1.5 | 0.5 | 0.0 | Balance |

[Table 2]

[Table 3]

| Examples | | Lower layer A | | | | | | | Upper layer B | | | | | |
|---|---|---|---|---|---|---|---|---|---|---|---|---|---|---|
| Type | Substrate | Furnace temp. (°C) | Nitrogen Partial Pressure (Pa) | Target composition (Alα sublayer) | Target composition (Alβ sublayer) | Bias voltage (-V) | Current (A) | Rotation number of turn table (rpm) | Nitrogen Partial Pressure (Pa) | Target composition | Furnace temp. (°C) | Bias voltage (-V) | Current (A) | Rotation number of turn table (rpm) |
| 1 | 1 | 320 | 2.6 | $Ti_{0.47}Al_{0.53}$ | $Ti_{0.47}Al_{0.78}$ | 125 | 210 | 2.7 | 0.4 | $Ti_{0.60}Al_{0.38}Si_{0.02}$ | 320 | 85 | 120 | 2.5 |
| 2 | 2 | 390 | 4.7 | $Ti_{0.63}Al_{0.37}$ | $Ti_{0.46}Al_{0.54}$ | 110 | 125 | 1.6 | 0.5 | $Ti_{0.31}Al_{0.55}Si_{0.14}$ | 390 | 90 | 155 | 4.5 |
| 3 | 3 | 420 | 5.5 | $Ti_{0.49}Al_{0.51}$ | $Ti_{0.28}Al_{0.72}$ | 75 | 155 | 1.6 | 0.4 | $Ti_{0.54}Al_{0.43}Si_{0.03}$ | 420 | 90 | 165 | 3.2 |
| 4 | 1 | 400 | 3.6 | $Ti_{0.57}Al_{0.43}$ | $Ti_{0.33}Al_{0.67}$ | 65 | 160 | 1.9 | 0.5 | $Ti_{0.42}Al_{0.50}Si_{0.08}$ | 410 | 115 | 145 | 1.8 |
| 5 | 2 | 330 | 7.5 | $Ti_{0.45}Al_{0.55}$ | $Ti_{0.33}Al_{0.67}$ | 50 | 190 | 2.5 | 0.6 | $Ti_{0.35}Al_{0.60}Si_{0.05}$ | 320 | 120 | 135 | 1.9 |
| 6 | 3 | 410 | 4.6 | $Ti_{0.54}Al_{0.46}$ | $Ti_{0.36}Al_{0.64}$ | 40 | 170 | 3.4 | 0.4 | $Ti_{0.59}Al_{0.40}Si_{0.01}$ | 400 | 65 | 190 | 1.9 |
| 7 | 1 | 550 | 3.7 | $Ti_{0.64}Al_{0.36}$ | $Ti_{0.36}Al_{0.64}$ | 70 | 150 | 3.9 | 0.5 | $Ti_{0.49}Al_{0.48}Si_{0.03}$ | 540 | 75 | 210 | 3.9 |
| 8 | 2 | 540 | 2.9 | $Ti_{0.51}Al_{0.49}$ | $Ti_{0.37}Al_{0.63}$ | 80 | 165 | 4.2 | 0.6 | $Ti_{0.34}Al_{0.57}Si_{0.09}$ | 530 | 65 | 220 | 2.4 |
| 9 | 3 | 380 | 4.8 | $Ti_{0.46}Al_{0.54}$ | $Ti_{0.25}Al_{0.75}$ | 100 | 195 | 1.9 | 0.5 | $Ti_{0.50}Al_{0.48}Si_{0.02}$ | 400 | 40 | 180 | 2.3 |

| | Type | Substrate | Lower layer A | | | | | | | | Upper layer B | | | | |
|---|---|---|---|---|---|---|---|---|---|---|---|---|---|---|---|
| | | | Furnace temp. (°C) | Nitrogen Partial Pressure (Pa) | Target composition (Al α sublayer) | Target composition (Al β sublayer) | Bias voltage (-V) | Current (A) | Rotation number of turn table (rpm) | Nitrogen Partial Pressure (Pa) | Target composition | Furnace temp. (°C) | Bias voltage (-V) | Current (A) | Rotation number of turn table (rpm) |
| Comparative Examples | 1 | 1 | 300 | 3.4 | $Ti_{0.52}Al_{0.48}$ | $Ti_{0.33}Al_{0.67}$ | 120 | 200 | 1.8 | 0.43 | $Ti_{0.56}Al_{0.43}Si_{0.01}$ | 340 | 85 | 150 | 2.3 |
| | 2 | 2 | 380 | 2.8 | $Ti_{0.39}Al_{0.61}$ | $Ti_{0.22}Al_{0.78}$ | 105 | 210 | 1.4 | 0.39 | $Ti_{0.56}Al_{0.40}Si_{0.04}$ | 380 | 45 | 130 | 2.5 |
| | 3 | 3 | 420 | 6.8 | $Ti_{0.48}Al_{0.52}$ | $Ti_{0.31}Al_{0.69}$ | 85 | 180 | 1.6 | 0.43 | $Ti_{0.52}Al_{0.45}Si_{0.03}$ | 410 | 90 | 125 | 3.0 |
| | 4 | 1 | 530 | 7.3 | $Ti_{0.51}Al_{0.49}$ | $Ti_{0.29}Al_{0.71}$ | 45 | 150 | 2.2 | 0.41 | $Ti_{0.50}Al_{0.43}Si_{0.07}$ | 520 | 70 | 155 | 4.1 |
| | 5 | 2 | 320 | 4.5 | $Ti_{0.45}Al_{0.55}$ | $Ti_{0.38}Al_{0.62}$ | 60 | 190 | 2.9 | 0.47 | $Ti_{0.49}Al_{0.50}Si_{0.01}$ | 320 | 100 | 180 | 5.6 |
| | 6 | 3 | 390 | 2.4 | $Ti_{0.54}Al_{0.46}$ | $Ti_{0.39}Al_{0.61}$ | 75 | 145 | 4.3 | 0.39 | $Ti_{0.58}Al_{0.40}Si_{0.02}$ | 400 | 115 | 190 | 3.1 |
| | 7 | 1 | 450 | 3.9 | $Ti_{0.58}Al_{0.42}$ | $Ti_{0.22}Al_{0.78}$ | 115 | 155 | 2.5 | - | - | - | - | - | - |
| | 8 | 2 | 510 | 4.6 | $Ti_{0.51}Al_{0.49}$ | $Ti_{0.34}Al_{0.66}$ | 35 | 185 | 1.8 | 0.45 | $Ti_{0.46}Al_{0.50}Si_{0.04}$ | 500 | 80 | 195 | 2.9 |
| | 9 | 3 | 470 | 4.1 | $Ti_{0.59}Al_{0.41}$ | $Ti_{0.38}Al_{0.62}$ | 60 | 190 | 2.4 | 0.40 | $Ti_{0.54}Al_{0.45}Si_{0.01}$ | 480 | 35 | 155 | 1.6 |

In Table 3, symbol "-" indicates no applicable items.

.

[Table 4]

[Table 5]

| Type | | Substrate | Lower layer A | | | | | | | | | | | | | | | | Upper layer B | | | | |
|---|---|---|---|---|---|---|---|---|---|---|---|---|---|---|---|---|---|---|---|---|---|---|---|---|
| | | | | Bottom half segment A1 | | | | | | | Top half segment A2 | | | | | | | | Nitrogen Partial Pressure (Pa) | Target composition | Furnace temp. (°C) | Bias voltage (-V) | Current (A) |
| | | | Furnace temp. (°C) | Nitrogen Partial Pressure (Pa) | Target composition (A1α sublayer) | Target composition (A1β sublayer) | Bias voltage (-V) | Current (A) | Rotation number of turn table (rpm) | Nitrogen Partial Pressure (Pa) | Target composition (A2γ sublayer) | Target composition (A2δ sublayer) | Bias voltage (-V) | Current (A) | Rotation number of turn table (rpm) | | | | | | | | |
| Examples | 11 | 1 | 320 | 1.0 | $Ti_{0.55}Al_{0.45}$ | $Ti_{0.20}Al_{0.80}$ | 50 | 180 | 3.2 | 3.2 | $Ti_{0.65}Al_{0.35}$ | $Ti_{0.30}Al_{0.70}$ | 60 | 180 | 2.5 | 2.5 | $Ti_{0.42}Al_{0.55}Si_{0.03}$ | 370 | 100 | 150 |
| | 12 | 2 | 480 | 4.2 | $Ti_{0.58}Al_{0.42}$ | $Ti_{0.30}Al_{0.70}$ | 65 | 200 | 6.2 | 3.7 | $Ti_{0.45}Al_{0.55}$ | $Ti_{0.35}Al_{0.65}$ | 100 | 200 | 3.3 | 3.2 | $Ti_{0.50}Al_{0.35}Si_{0.15}$ | 400 | 75 | 130 |
| | 13 | 3 | 480 | 5.0 | $Ti_{0.60}Al_{0.40}$ | $Ti_{0.30}Al_{0.70}$ | 35 | 230 | 1.6 | 5.1 | $Ti_{0.65}Al_{0.35}$ | $Ti_{0.35}Al_{0.65}$ | 120 | 220 | 1.9 | 2.9 | $Ti_{0.38}Al_{0.60}Si_{0.02}$ | 520 | 80 | 200 |
| | 14 | 1 | 450 | 8.2 | $Ti_{0.45}Al_{0.55}$ | $Ti_{0.25}Al_{0.75}$ | 30 | 200 | 1.4 | 7.5 | $Ti_{0.55}Al_{0.45}$ | $Ti_{0.25}Al_{0.75}$ | 70 | 210 | 1.7 | 5.6 | $Ti_{0.43}Al_{0.48}Si_{0.09}$ | 430 | 120 | 180 |
| | 15 | 2 | 600 | 4.3 | $Ti_{0.50}Al_{0.50}$ | $Ti_{0.30}Al_{0.70}$ | 45 | 150 | 2.2 | 5.4 | $Ti_{0.65}Al_{0.35}$ | $Ti_{0.31}Al_{0.69}$ | 100 | 250 | 1.6 | 4.5 | $Ti_{0.52}Al_{0.40}Si_{0.08}$ | 410 | 100 | 150 |
| | 16 | 3 | 540 | 7.1 | $Ti_{0.60}Al_{0.40}$ | $Ti_{0.20}Al_{0.80}$ | 85 | 100 | 3.5 | 5.5 | $Ti_{0.65}Al_{0.35}$ | $Ti_{0.38}Al_{0.62}$ | 135 | 230 | 2.7 | 6.2 | $Ti_{0.42}Al_{0.55}Si_{0.03}$ | 320 | 60 | 200 |
| | 17 | 1 | 300 | 2.2 | $Ti_{0.43}Al_{0.57}$ | $Ti_{0.17}Al_{0.83}$ | 55 | 140 | 3.9 | 6.4 | $Ti_{0.58}Al_{0.42}$ | $Ti_{0.25}Al_{0.75}$ | 90 | 160 | 2.2 | 7.7 | $Ti_{0.44}Al_{0.41}Si_{0.15}$ | 280 | 180 | 175 |
| | 18 | 2 | 340 | 4.5 | $Ti_{0.50}Al_{0.50}$ | $Ti_{0.35}Al_{0.65}$ | 100 | 220 | 3.3 | 3.5 | $Ti_{0.64}Al_{0.36}$ | $Ti_{0.40}Al_{0.60}$ | 100 | 225 | 2.9 | 6.7 | $Ti_{0.58}Al_{0.37}Si_{0.05}$ | 350 | 45 | 125 |
| | 19 | 3 | 400 | 6.2 | $Ti_{0.54}Al_{0.46}$ | $Ti_{0.22}Al_{0.78}$ | 120 | 210 | 2.7 | 4.6 | $Ti_{0.65}Al_{0.35}$ | $Ti_{0.31}Al_{0.69}$ | 80 | 115 | 1.3 | 5.4 | $Ti_{0.35}Al_{0.60}Si_{0.05}$ | 390 | 55 | 145 |

| Type | Substrate | Lower layer A | | | | | | | | | | | | | Upper layer B | | | | |
|---|---|---|---|---|---|---|---|---|---|---|---|---|---|---|---|---|---|---|---|
| | | | Bottom half segment A1 | | | | | | Top half segment A2 | | | | | | Nitrogen Partial Pressure (Pa) | Target composition | Furnace temp. (°C) | Bias voltage (-V) | Current (A) |
| | | Furnace temp. (°C) | Nitrogen Partial Pressure (Pa) | Target composition (A1α sublayer) | Target composition (A1β sublayer) | Bias voltage (-V) | Current (A) | Rotation number of turn table (rpm) | Nitrogen Partial Pressure (Pa) | Target composition (A2γ sublayer) | Target composition (A2δ sublayer) | Bias voltage (-V) | Current (A) | Rotation number of turn table (rpm) | | | | | |
| Comparative Examples 11 | 1 | 320 | 1.0 | $Ti_{0.30}Al_{0.70}$ | $Ti_{0.10}Al_{0.90}$ | 50 | 180 | 3.18 | 3.2 | $Ti_{0.67}Al_{0.33}$ | $Ti_{0.33}Al_{0.67}$ | 60 | 180 | 2.5 | 2.5 | $Ti_{0.37}Al_{0.55}Si_{0.08}$ | 370 | 100 | 150 |
| 12 | 2 | 590 | 4.2 | $Ti_{0.55}Al_{0.45}$ | $Ti_{0.30}Al_{0.70}$ | 45 | 220 | 3.2 | 2.2 | $Ti_{0.68}Al_{0.32}$ | $Ti_{0.36}Al_{0.64}$ | 120 | 200 | 1.9 | 4.3 | $Ti_{0.41}Al_{0.44}Si_{0.15}$ | 550 | 110 | 180 |
| 13 | 3 | 520 | 3.2 | $Ti_{0.46}Al_{0.54}$ | $Ti_{0.26}Al_{0.74}$ | 100 | 210 | 4.3 | 3.4 | $Ti_{0.61}Al_{0.39}$ | $Ti_{0.28}Al_{0.72}$ | 110 | 220 | 2.4 | 2.5 | $Ti_{0.60}Al_{0.35}Si_{0.05}$ | 500 | 80 | 220 |
| 14 | 1 | 430 | 3.7 | $Ti_{0.56}Al_{0.44}$ | $Ti_{0.39}Al_{0.61}$ | 150 | 180 | 3.1 | 5.1 | $Ti_{0.62}Al_{0.38}$ | $Ti_{0.41}Al_{0.59}$ | 40 | 230 | 1.6 | 6.7 | $Ti_{0.58}Al_{0.37}Si_{0.05}$ | 430 | 95 | 140 |
| 15 | 2 | 370 | 8.5 | $Ti_{0.52}Al_{0.48}$ | $Ti_{0.28}Al_{0.72}$ | 50 | 150 | 1.9 | 4.7 | $Ti_{0.54}Al_{0.46}$ | $Ti_{0.36}Al_{0.64}$ | 50 | 140 | 1.1 | 8.5 | $Ti_{0.39}Al_{0.60}Si_{0.01}$ | 350 | 75 | 170 |
| 16 | 3 | 490 | 3.7 | $Ti_{0.47}Al_{0.53}$ | $Ti_{0.31}Al_{0.69}$ | 65 | 175 | 1.5 | 6.5 | $Ti_{0.46}Al_{0.54}$ | $Ti_{0.35}Al_{0.65}$ | 75 | 110 | 1.3 | 7.0 | $Ti_{0.39}Al_{0.55}Si_{0.06}$ | 500 | 50 | 190 |
| 17 | 1 | 440 | 5.5 | $Ti_{0.45}Al_{0.55}$ | $Ti_{0.20}Al_{0.80}$ | 85 | 125 | 1.7 | 3.8 | $Ti_{0.68}Al_{0.32}$ | $Ti_{0.36}Al_{0.64}$ | 95 | 170 | 1.5 | 4.2 | $Ti_{0.47}Al_{0.50}Si_{0.03}$ | 440 | 45 | 195 |
| 18 | 2 | 290 | 2.6 | $Ti_{0.45}Al_{0.55}$ | $Ti_{0.40}Al_{0.60}$ | 120 | 225 | 3.2 | 8.6 | $Ti_{0.50}Al_{0.50}$ | $Ti_{0.42}Al_{0.58}$ | 150 | 195 | 3.8 | 2.3 | $Ti_{0.52}Al_{0.42}Si_{0.06}$ | 300 | 35 | 215 |
| 19 | 3 | 360 | 3.7 | $Ti_{0.42}Al_{0.58}$ | $Ti_{0.17}Al_{0.83}$ | 110 | 190 | 4 | 2.6 | $Ti_{0.43}Al_{0.57}$ | $Ti_{0.30}Al_{0.70}$ | 110 | 215 | 2.6 | 1.9 | $Ti_{0.45}Al_{0.50}Si_{0.05}$ | 360 | 40 | 130 |

[Table 6]

| | | Outermost layer | | | | |
|---|---|---|---|---|---|---|
| Type | | Furnace Temp. (°C) | Nitrogen partial pressure (Pa) | Target composition | Biasing voltage (−V) | Current (A) |
| Deposition conditions of outermost layer | 1 | 300 | 2.4 | Ti | 120 | 200 |
| | 2 | 420 | 4.4 | Ti | 105 | 250 |
| | 3 | 530 | 9.0 | Ti | 85 | 180 |
| | 4 | 510 | 7.3 | Ti | 45 | 150 |
| | 5 | 435 | 0.5 | Ti | 60 | 190 |
| | 6 | 450 | 2.4 | Ti | 75 | 50 |
| | 7 | 550 | 3.9 | Ti | 500 | 155 |
| | 8 | 600 | 6.9 | Ti | 20 | 185 |
| | 9 | 490 | 6.3 | Ti | 60 | 190 |

[Table 7]

| | Examples | | | | | | | | | Comparative Examples | | | | | | | | |
|---|---|---|---|---|---|---|---|---|---|---|---|---|---|---|---|---|---|---|
| Type | 1 | 2 | 3 | 4 | 5 | 6 | 7 | 8 | 9 | 1 | 2 | 3 | 4 | 5 | 6 | 7 | 8 | 9 |
| Substrate | 1 | 2 | 3 | 1 | 2 | 3 | 1 | 2 | 3 | 1 | 2 | 3 | 1 | 2 | 3 | 1 | 2 | 3 |
| Outermost layer | 1 | 2 | 3 | 4 | 5 | – | 7 | 8 | – | – | 2 | 3 | – | 5 | 6 | – | 8 | 9 |
| Coating layer — Lower layer A — Average thickness $A_t$ (μm) | 1.3 | 5.4 | 0.4 | 2.4 | 5.7 | 4.5 | 3.2 | 2.3 | 1.4 | 1.8 | 3.3 | 3.2 | 5.9 | 2.9 | 1.1 | 3.5 | 6.4 | 3.0 |
| Average thickness $\alpha_t$ (nm) | 2.3 | 3.5 | 1.1 | 2.1 | 1.7 | 3.1 | 2.7 | 0.8 | 2.4 | 2.7 | 3.4 | 1.9 | 2.9 | 1.0 | 2.7 | 2.3 | 2.4 | 1.5 |
| Average thickness $\beta_t$ (nm) | 2.4 | 3.9 | 0.9 | 1.8 | 1.9 | 2.8 | 2.3 | 1.0 | 2.6 | 3.8 | 3.2 | 1.5 | 3.0 | 1.2 | 1.3 | 2.3 | 2.3 | 1.3 |
| $\beta_t / \alpha_t$ | 1.0 | 1.1 | 0.8 | 0.9 | 1.1 | 0.9 | 0.9 | 1.3 | 1.1 | 1.4 | 0.9 | 0.8 | 1.0 | 1.2 | 0.5 | 1.0 | 1.0 | 0.9 |
| $X_{avg}$ | 0.53 | 0.37 | 0.51 | 0.43 | 0.55 | 0.46 | 0.36 | 0.49 | 0.54 | 0.48 | 0.61 | 0.52 | 0.49 | 0.55 | 0.46 | 0.42 | 0.49 | 0.41 |
| $Y_{avg}$ | 0.78 | 0.61 | 0.72 | 0.67 | 0.67 | 0.64 | 0.64 | 0.63 | 0.75 | 0.67 | 0.78 | 0.69 | 0.71 | 0.62 | 0.61 | 0.78 | 0.66 | 0.62 |
| $Y_{avg}/X_{avg}$ | 1.5 | 1.6 | 1.4 | 1.6 | 1.2 | 1.4 | 1.8 | 1.3 | 1.4 | 1.4 | 1.3 | 1.3 | 1.4 | 1.1 | 1.3 | 1.9 | 1.3 | 1.5 |
| Number m of deposited A1 α sublayers | 138 | 365 | 100 | 308 | 792 | 381 | 320 | 639 | 140 | 138 | 250 | 471 | 500 | 659 | 137 | 380 | 681 | 534 |
| Number n of deposited A1 β sublayers | 139 | 365 | 100 | 308 | 791 | 382 | 320 | 639 | 140 | 139 | 250 | 470 | 500 | 659 | 138 | 381 | 681 | 535 |
| Sum m+n of A1 α sublayers and A1 β sublayers | 277 | 730 | 200 | 615 | 1583 | 763 | 640 | 1278 | 280 | 277 | 500 | 941 | 1000 | 1318 | 275 | 761 | 1362 | 1071 |
| Upper layer B — Average thickness $B_t$ (μm) | 0.5 | 1.1 | 0.2 | 0.9 | 2.8 | 2.1 | 1.0 | 1.1 | 0.5 | 0.7 | 0.9 | 2.9 | 3.2 | 1.2 | 0.3 | – | 1.4 | 2.8 |
| $a_{avg}$ | 0.36 | 0.53 | 0.42 | 0.48 | 0.58 | 0.39 | 0.46 | 0.55 | 0.45 | 0.43 | 0.39 | 0.43 | 0.41 | 0.47 | 0.39 | – | 0.45 | 0.40 |
| $b_{avg}$ | 0.02 | 0.14 | 0.03 | 0.08 | 0.05 | 0.01 | 0.03 | 0.09 | 0.02 | 0.01 | 0.04 | 0.03 | 0.07 | 0.01 | 0.02 | – | 0.04 | 0.01 |
| $A_t/B_t$ | 2.6 | 4.9 | 2.0 | 2.7 | 2.0 | 2.1 | 3.2 | 2.1 | 2.8 | 2.6 | 3.7 | 1.1 | 1.8 | 2.4 | 3.7 | – | 4.6 | 1.1 |
| Average thickness (μm) of TiN outermost layer | 1.0 | 0.2 | 0.4 | 0.5 | 0.3 | – | 0.1 | 0.1 | – | – | 0.4 | 0.3 | – | 0.6 | 0.5 | – | 0.2 | 0.1 |

In Table 7, "-" indicates no applicable items.

[Table 8]

| | Example 11 | Example 12 | Example 13 | Example 14 | Example 15 | Example 16 | Example 17 | Example 18 | Example 19 | Comp. Ex. 11 | Comp. Ex. 12 | Comp. Ex. 13 | Comp. Ex. 14 | Comp. Ex. 15 | Comp. Ex. 16 | Comp. Ex. 17 | Comp. Ex. 18 | Comp. Ex. 19 |
|---|---|---|---|---|---|---|---|---|---|---|---|---|---|---|---|---|---|---|
| Type | 11 | 12 | 13 | 14 | 15 | 16 | 17 | 18 | 19 | 11 | 12 | 13 | 14 | 15 | 16 | 17 | 18 | 19 |
| Substrate | 1 | 2 | 3 | 1 | 2 | 3 | 1 | 2 | 3 | 1 | 2 | 3 | 1 | 2 | 3 | 1 | 2 | 3 |
| Outermost layer | 1 | - | 3 | 4 | 5 | 6 | 7 | 8 | 9 | 1 | 2 | 3 | 4 | 5 | 6 | 7 | 8 | - |
| **Coating layer — Bottom half segment A1** — Average thickness A1t (μm) | 1.3 | 0.4 | 4.3 | 3.1 | 0.9 | 2.1 | 1.7 | 0.6 | 1.9 | 1.2 | 2.0 | 3.3 | 4.2 | 1.1 | 4.2 | 1.5 | — | 2.5 |
| Average thickness αt (nm) | 2.2 | 0.5 | 3.8 | 1.2 | 2.8 | 0.8 | 3.4 | 1.9 | 2.4 | 2.4 | 0.9 | 1.0 | 2.1 | 5.2 | 2.7 | 0.7 | 3.2 | 5.2 |
| Average thickness βt (nm) | 2.1 | 0.6 | 3.9 | 1.4 | 2.2 | 0.7 | 2.7 | 1.8 | 2.8 | 2.1 | 0.7 | 1.0 | 1.9 | 4.9 | 2.3 | 0.7 | 3.2 | 5.4 |
| βt/αt | 1.0 | 1.2 | 1.2 | 1.2 | 0.8 | 0.9 | 0.8 | 1.2 | 0.9 | 0.8 | 1.0 | 0.9 | 0.9 | 1.0 | 0.9 | 0.9 | 1.0 | 1.0 |
| x_AVE | 0.42 | 0.54 | 0.39 | 0.52 | 0.48 | 0.36 | 0.54 | 0.45 | 0.43 | 0.68 | 0.42 | 0.54 | 0.44 | 0.48 | 0.33 | 0.55 | 0.58 | 0.58 |
| y_AVE | 0.78 | 0.65 | 0.67 | 0.73 | 0.69 | 0.77 | 0.79 | 0.62 | 0.74 | 0.87 | 0.67 | 0.74 | 0.61 | 0.72 | 0.69 | 0.80 | 0.60 | 0.83 |
| y_AVE/x_AVE | 1.9 | 1.2 | 1.7 | 1.4 | 1.4 | 2.1 | 1.5 | 1.4 | 1.7 | 1.3 | 1.6 | 1.4 | 1.5 | 2.1 | 1.5 | 1.5 | — | 1.4 |
| Number p of deposited A1α sublayers | 151 | 182 | 279 | 596 | 90 | 700 | 139 | 27 | 183 | 134 | 625 | 785 | 488 | 208 | 110 | 821 | 123 | 118 |
| Number q of deposited A1β sublayers | 151 | 182 | 279 | 596 | 90 | 700 | 140 | 27 | 182 | 133 | 625 | 786 | 487 | 208 | 110 | 822 | 123 | 118 |
| Sum p+q of A1α sublayers and A1β sublayers | 302 | 364 | 558 | 1192 | 180 | 1400 | 279 | 54 | 365 | 267 | 1250 | 1571 | 975 | 416 | 220 | 1643 | 246 | 236 |
| **Top Half segment A2** — Average thickness A2t (nm) | 1.4 | 0.2 | 1.5 | 1.1 | 1.3 | 2.8 | 1.2 | 0.4 | 3.3 | 1.4 | 0.4 | 1.0 | 4.4 | 1.5 | 1.6 | 1.2 | 2.3 | 1.2 |
| Average thickness γt (nm) | 4.2 | 3.2 | 7.6 | 2.1 | 3.2 | 1.7 | 5.3 | 3.2 | 2.9 | 4.2 | 3.4 | 3.7 | 7.6 | 3.1 | 6.2 | 5.1 | — | 4.0 |
| Average thickness δt (nm) | 4.5 | 3.1 | 6.2 | 2.2 | 3.2 | 1.8 | 5.1 | 3.9 | 3.2 | 4.5 | 3.6 | 3.8 | 8.3 | 3.2 | 5.7 | 5.0 | — | 4.3 |
| δt/γt | 1.1 | 1.0 | 0.8 | 1.0 | 1.0 | 1.1 | 1.0 | 1.1 | 1.1 | 1.0 | 1.1 | 1.0 | 0.9 | 1.0 | 1.0 | 1.0 | — | 1.1 |
| Z_AVE | 0.33 | 0.49 | 0.31 | 0.41 | 0.44 | 0.33 | 0.38 | 0.42 | 0.32 | 0.33 | 0.32 | 0.39 | 0.46 | 0.54 | 0.32 | 0.50 | 0.57 | 0.57 |
| W_AVE | 0.67 | 0.63 | 0.59 | 0.71 | 0.65 | 0.58 | 0.72 | 0.55 | 0.64 | 0.67 | 0.64 | 0.59 | 0.64 | 0.65 | 0.64 | 0.58 | 0.70 | 0.70 |
| W_AVE/Z_AVE | 2.0 | 1.3 | 1.9 | 1.7 | 1.5 | 1.8 | 1.9 | 1.3 | 2.0 | 2.0 | 1.8 | 1.6 | 1.4 | 1.2 | 2.0 | 1.2 | 1.2 | 1.2 |
| Number r of deposited A2α sublayers | 80 | 16 | 55 | 128 | 102 | 400 | 57 | 28 | 270 | 80 | 28 | 114 | 294 | 47 | 127 | 51 | 114 | 72 |
| Number s of deposited A2β sublayers | 81 | 16 | 54 | 128 | 101 | 400 | 58 | 28 | 271 | 81 | 29 | 113 | 293 | 47 | 127 | 50 | 114 | 73 |
| Sum r+s of A2α sublayers and A2β sublayers | 161 | 32 | 109 | 256 | 203 | 800 | 115 | 56 | 541 | 161 | 57 | 227 | 587 | 94 | 254 | 101 | 228 | 145 |
| **Lower layer A** — Average thickness At (μm) | 2.7 | 0.6 | 5.8 | 4.2 | 2.2 | 4.9 | 2.9 | 0.6 | 5.2 | 2.6 | 2.4 | 4.3 | 8.3 | 5.7 | 2.7 | 3.5 | 3.8 | 3.7 |
| Atu/Atl | 0.9 | 2.0 | 2.9 | 2.8 | 0.7 | 0.8 | 1.4 | 0.5 | 0.6 | 0.9 | 5.0 | 3.3 | 2.8 | 0.7 | 1.9 | 0.7 | — | 2.1 |
| (γt+δt)/(αt+βt) | 2.0 | 5.7 | 1.8 | 1.7 | 1.3 | 2.3 | 1.7 | 1.9 | 1.2 | 1.9 | 4.4 | 2.1 | 1.9 | 1.6 | 1.3 | 8.5 | 1.7 | 0.8 |
| X_AVE−Z_AVE | 0.09 | 0.05 | 0.08 | 0.11 | 0.04 | 0.03 | 0.16 | 0.03 | 0.35 | 0.10 | 0.15 | 0.06 | 0.02 | -0.21 | 0.23 | 0.05 | — | 0.01 |
| Y_AVE−W_AVE | 0.11 | 0.02 | 0.08 | 0.02 | 0.04 | 0.19 | 0.07 | 0.07 | 0.10 | 0.20 | 0.03 | 0.02 | 0.08 | 0.04 | 0.16 | 0.02 | — | 0.13 |
| **Upper layer B** — Average thickness Bt (nm) | 1.3 | 0.2 | 2.8 | 1.8 | 0.6 | 2.3 | 0.7 | 0.3 | 1.1 | 1.4 | 1.5 | 1.1 | 2.7 | 0.7 | 2.7 | 1.3 | — | 1.9 |
| a_AVE | 0.52 | 0.42 | 0.44 | 0.58 | 0.44 | 0.38 | 0.51 | 0.41 | 0.35 | 0.56 | 0.51 | 0.41 | 0.33 | 0.59 | 0.54 | 0.46 | 0.38 | 0.47 |
| b_AVE | 0.02 | 0.12 | 0.01 | 0.09 | 0.07 | 0.03 | 0.15 | 0.03 | 0.05 | 0.08 | 0.15 | 0.05 | 0.05 | 0.01 | 0.06 | 0.03 | 0.06 | 0.05 |
| At/Bt | 2.1 | 3.0 | 2.1 | 2.3 | 3.7 | 2.1 | 4.1 | 2.0 | 4.7 | 1.9 | 1.6 | 2.4 | 7.5 | 2.1 | 3.9 | 1.3 | 2.9 | 1.9 |
| Average thickness (μm) of TiN of outermost layer | 0.2 | - | 0.1 | 0.4 | 0.3 | 0.1 | 0.9 | 0.2 | 0.3 | 0.4 | 0.7 | 0.2 | 0.1 | 0.3 | 0.5 | 0.8 | — | - |

In Table 8, symbol "-" indicates no applicable items.

Examples 1 to 9, and 11 to 19 and Comparative Examples 1 to 9 and 11 to 19 were subjected to Cutting tests 1 to 3 under the following cutting conditions:

Cutting test 1

Cutting conditions:

Workpiece: 60 mm wide by 200 mm long block material (stainless steel SUS304)
Cutting speed: 160 m/min.
Depth of cut: 1.5 mm
Feed: 0.10 mm/tooth.

The workpiece was cut to a cutting length of 2.0 m, and the wear width of the flank face was measured while the worn state of the cutting edge was observed. Since the wear width of the flank face includes the wear width caused by oxidation damage and boundary damage, the suppression of oxidation damage and boundary damage can also be evaluated.
The results of the cutting tests are shown in Tables 9 and 10.

Cutting test 2

Cutting conditions:

Workpiece: 60 mm wide by 200 mm long block material (ductile cast iron FCD450)

Cutting speed: 180 m/min.
Depth of cut: 1.2 mm
Feed: 0.10 mm/tooth.

The workpiece was cut to a cutting length of 10.0 m, and the wear width of the flank face was measured while the worn state of the cutting edge was observed.
The results of the cutting tests are shown in Tables 11 and 12.

Cutting test 3

Cutting conditions:

Workpiece: 60 mm wide by 200 mm long block material (chrome molybdenum steel SNCM435)

Cutting speed: 200 m/min.
Depth of cut: 1.2 mm
Feed: 0.10 mm/tooth.

The workpiece was cut to a cutting length of 10.0 m, and the wear width of the flank face was measured while the worn state of the cutting edge was observed.
The results of the cutting tests are shown in Tables 13 and 14.

[Table 9]

| Type | | Wear on flank face (mm) | Chipping | Type | | Wear on flank face (mm) | Chipping |
|---|---|---|---|---|---|---|---|
| Examples | 1 | 0.04 | Not observed | Comparative Examples | 1 | 0.30 | Observed |
| | 2 | 0.02 | Not observed | | 2 | 0.35 | Observed |
| | 3 | 0.01 | Not observed | | 3 | 0.23 | Observed |
| | 4 | 0.04 | Not observed | | 4 | 0.19 | Not observed |
| | 5 | 0.04 | Not observed | | 5 | 0.25 | Observed |
| | 6 | 0.05 | Not observed | | 6 | 0.32 | Observed |
| | 7 | 0.02 | Not observed | | 7 | *50 | Observed |
| | 8 | 0.05 | Not observed | | 8 | 0.27 | Observed |
| | 9 | 0.05 | Not observed | | 9 | 0.42 | Observed |

In Table 9, symbol * indicates the service life (sec) in the sample which reached the service life before reaching the maximum cutting length.

[Table 10]

| Type | | Wear on flank face (mm) | Chipping | Type | | Wear on flank face (mm) | Chipping |
|---|---|---|---|---|---|---|---|
| Examples | 11 | 0.03 | Not observed | Comparative Examples | 11 | 0.21 | Not observed |
| | 12 | 0.02 | Not observed | | 12 | 0.09 | Observed |
| | 13 | 0.04 | Not observed | | 13 | 0.19 | Observed |
| | 14 | 0.03 | Not observed | | 14 | 0.22 | Observed |
| | 15 | 0.02 | Not observed | | 15 | 0.18 | Observed |
| | 16 | 0.03 | Not observed | | 16 | 0.29 | Observed |
| | 17 | 0.04 | Not observed | | 17 | 0.24 | Observed |
| | 18 | 0.05 | Not observed | | 18 | 0.31 | Observed |
| | 19 | 0.02 | Not observed | | 19 | 0.43 | Observed |

[Table 11]

| | Type | Wear on flank face (mm) | Chipping | | Type | Wear on flank face (mm) | Chipping |
|---|---|---|---|---|---|---|---|
| Examples | 1 | 0.09 | Not observed | Comparative Examples | 1 | 0.29 | Observed |
| | 2 | 0.04 | Not observed | | 2 | 0.46 | Observed |
| | 3 | 0.12 | Not observed | | 3 | 0.22 | Not observed |
| | 4 | 0.07 | Not observed | | 4 | 0.45 | Observed |
| | 5 | 0.08 | Not observed | | 5 | 0.55 | Observed |
| | 6 | 0.05 | Not observed | | 6 | 0.60 | Observed |
| | 7 | 0.04 | Not observed | | 7 | 0.48 | Observed |
| | 8 | 0.11 | Not observed | | 8 | 0.95 | Observed |
| | 9 | 0.04 | Not observed | | 9 | 0.34 | Observed |

[Table 12]

| | Type | Wear on flank face (mm) | Chipping | | Type | Wear on flank face (mm) | Chipping |
|---|---|---|---|---|---|---|---|
| Examples | 11 | 0.04 | Not observed | Comparative Examples | 11 | 0.98 | Observed |
| | 12 | 0.11 | Not observed | | 12 | 0.75 | Observed |
| | 13 | 0.10 | Not observed | | 13 | 0.32 | Observed |
| | 14 | 0.08 | Not observed | | 14 | 0.29 | Not observed |
| | 15 | 0.05 | Not observed | | 15 | 0.76 | Observed |
| | 16 | 0.06 | Not observed | | 16 | 0.77 | Observed |
| | 17 | 0.04 | Not observed | | 17 | 0.65 | Observed |
| | 18 | 0.07 | Not observed | | 18 | 0.89 | Observed |
| | 19 | 0.09 | Not observed | | 19 | 0.92 | Observed |

[Table 13]

| Type | | Wear on flank face (mm) | Chipping | Type | | Wear on flank face (mm) | Chipping |
|---|---|---|---|---|---|---|---|
| Examples | 1 | 0.06 | Not observed | Comparative Examples | 1 | 0.38 | Observed |
| | 2 | 0.09 | Not observed | | 2 | 0.67 | Observed |
| | 3 | 0.05 | Not observed | | 3 | 0.24 | Observed |
| | 4 | 0.04 | Not observed | | 4 | 0.14 | Not observed |
| | 5 | 0.03 | Not observed | | 5 | 0.26 | Observed |
| | 6 | 0.05 | Not observed | | 6 | 0.28 | Observed |
| | 7 | 0.09 | Not observed | | 7 | 0.18 | Not observed |
| | 8 | 0.10 | Not observed | | 8 | 0.14 | Not observed |
| | 9 | 0.04 | Not observed | | 9 | 0.18 | Not observed |

[Table 14]

| Type | | Wear on flank face (mm) | Chipping | Type | | Wear on flank face (mm) | Chipping |
|---|---|---|---|---|---|---|---|
| Examples | 11 | 0.04 | Not observed | Comparative Examples | 11 | 0.86 | Observed |
| | 12 | 0.09 | Not observed | | 12 | 0.25 | Not observed |
| | 13 | 0.10 | Not observed | | 13 | 0.68 | Observed |
| | 14 | 0.08 | Not observed | | 14 | 0.22 | Not observed |
| | 15 | 0.05 | Not observed | | 15 | 0.21 | Not observed |
| | 16 | 0.08 | Not observed | | 16 | 0.55 | Observed |
| | 17 | 0.07 | Not observed | | 17 | 0.38 | Observed |
| | 18 | 0.06 | Not observed | | 18 | 0.70 | Observed |
| | 19 | 0.09 | Not observed | | 19 | 1.14 | Observed |

The results in Tables 9 to 14 demonstrate that all of Examples 1 to 9 and 11 to 19 exhibit no occurrence of abnormal damage, such as chipping or peeling, which indicates that they are excellent in both abrasion and chipping resistance.

In contrast, Comparative Examples 1 to 9 and 11 to 19 reach the service life within a short operational time due to the occurrence of chipping or the progression of wear on the flank face.

The foregoing disclosed embodiments are in all respects illustrative only and are not restrictive. The scope of the invention is indicated by the claims, not the aforementioned embodiments, and is intended to include all modifications within the meaning and scope of the claims and equivalents.

[Reference Signs List]

1 substrate
2 coated layer
3 lower layer A
4 upper layer B
5 bottom half segment A1
6 top half segment A2
7 A1$\alpha$ sublayer
8 A1$\beta$ sublayer
9 A2$_\gamma$ sublayer
10 A2$\delta$ sublayer

**Claims**

1. A surface coated cutting tool comprising a substrate and a coating layer on the substrate,

the coating layer comprising a lower layer A and an upper layer B on the lower layer A, wherein
the lower layer A has an average thickness At of 0.3 pm or more and 6.0 pm or less, and the upper layer B has an average thickness Bt of 0.1 pm or more and 3.0 pm or less, the average thicknesses satisfying the relation: $2.0 \leq At/Bt \leq 5.0$;
the lower layer A comprises an alternating laminate of A1$\alpha$ sublayers having an average thickness at and A1$\beta$ sublayers having an average thickness $\beta$t, the average thicknesses satisfying the relations: $0.5 \text{ nm} \leq at \leq 4.0 \text{ nm}$, $0.5 \text{ nm} \leq \beta t \leq 4.0 \text{ nm}$, and $0.7 \leq \beta t/at \leq 1.3$;
the A1$\alpha$ sublayers each have a composition represented by $Al_x Ti_{1-x}N$ (the average value $x_{avg}$ of x satisfying the relation: $0.35 \leq x_{avg} \leq 0.55$);
the A1$\beta$ sublayers each have a composition represented by $Al_y Ti_{1-y}N$ (the average value $y_{avg}$ of y satisfying the relation: $0.60 \leq y_{avg} \leq 0.80$);
the average values satisfy the relation: $1.2 \leq y_{avg}/x_{avg}$; and
the upper layer B has a composition represented by $Al_a Ti_{1-a-b}Si_b N$ (the average value $a_{avg}$ of a and the average value $b_{avg}$ of b, respectively, satisfying the relations: $0.35 \leq a_{avg} \leq 0.60$ and $0.00 < b_{avg} \leq 0.15$).

2. The surface coated cutting tool as claimed in claim 1, wherein

the lower layer A comprises a bottom half segment A1 in contact with the substrate and a top half segment A2 in contact with the upper layer B,
the bottom half segment A1 has an average thickness A1t and the top half segment A2 has an average thickness A2t, and the average thicknesses satisfy the relations: $0.1 \text{ pm} \leq A1t \leq 4.5 \text{ pm}$, $0.2 \text{ pm} \leq A2t \leq 4.0 \text{ pm}$, and $0.5 < A1t/A2t < 3.0$,
the bottom half segment A1 comprises a laminate of the alternating A1$\alpha$ and A1$\beta$ sublayers,
the top half segment A2 comprises an alternating laminate of A2$_\gamma$ sublayers having an average thickness $_\gamma$t and A2$\delta$ sublayers having an average thickness $\delta$t, the average thicknesses satisfying the relations: $1.5 \text{ nm} \leq _\gamma t \leq 8.0 \text{ nm}$, $1.5 \text{ nm} \leq \delta t \leq 8.0 \text{nm}$, $0.7 \leq \delta t/\gamma t \leq 1.3$, and $1.0 < (\gamma t + \delta t)/(\alpha t + \beta t) < 6.0$,
the A2$_\gamma$ sublayers have a composition represented by $Al_z Ti_{1-z}N$ (where the average value $z_{avg}$ of z satisfies the relation: $0.30 \leq z_{avg} \leq 0.50$),
the A2$\delta$ sublayers each have a composition represented by $Al_w Ti_{1-w}N$ (where the average value $w_{avg}$ of w satisfies the relation: $0.55 \leq w_{avg} \leq 0.75$), and
the average value $w_{avg}$, the average value $x_{avg}$, the average value $y_{avg}$, and the average value $z_{avg}$ satisfy the relations: $1.2 \leq w_{avg}/z_{avg}$, $0.02 \leq (x_{avg}-z_{avg}) \leq 0.30$, and $0.02 \leq (y_{avg}-w_{avg}) \leq 0.30$.

[Fig. 1]

[Fig. 2]

## INTERNATIONAL SEARCH REPORT

International application No.

**PCT/JP2023/010248**

| A. | CLASSIFICATION OF SUBJECT MATTER |
|---|---|

*B23B 27/14*(2006.01)i; *B23B 51/00*(2006.01)i; *B23C 5/16*(2006.01)i; *B23P 15/28*(2006.01)i; *C23C 14/06*(2006.01)i; *C23C 14/32*(2006.01)i

FI: B23B27/14 A; C23C14/06 A; C23C14/32 Z; B23B51/00 J; B23C5/16; B23P15/28 A

According to International Patent Classification (IPC) or to both national classification and IPC

| B. | FIELDS SEARCHED |
|---|---|

Minimum documentation searched (classification system followed by classification symbols)

B23B27/14; B23B51/00; B23C5/16; B23P15/28; C23C14/06; C23C14/32

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2020-520814 A (WALTER AG) 16 July 2020 (2020-07-16) paragraphs [0015], [0021], [0037]-[0041] | 1-2 |
| A | WO 2017/022501 A1 (TUNGALOY CORP.) 09 February 2017 (2017-02-09) paragraph [0070] | 1-2 |
| A | WO 2015/186503 A1 (SUMITOMO ELECTRIC HARDMETAL CORP.) 10 December 2015 (2015-12-10) | 1-2 |
| A | JP 2018-501408 A (WALTER AG) 18 January 2018 (2018-01-18) | 1-2 |
| A | JP 2015-529571 A (WALTER AG) 08 October 2015 (2015-10-08) | 1-2 |

☐ Further documents are listed in the continuation of Box C.  ☑ See patent family annex.

| * | Special categories of cited documents: | | |
|---|---|---|---|
| "A" | document defining the general state of the art which is not considered to be of particular relevance | "T" | later document published after the international filing date or priority date and not in conflict with the application but cited to understand the principle or theory underlying the invention |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **25 April 2023** | **16 May 2023** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (January 2015)

**INTERNATIONAL SEARCH REPORT**
Information on patent family members

International application No.

**PCT/JP2023/010248**

| Patent document cited in search report | | | Publication date (day/month/year) | Patent family member(s) | | | Publication date (day/month/year) |
|---|---|---|---|---|---|---|---|
| JP | 2020-520814 | A | 16 July 2020 | US | 2020/0181756 | A1 | |
| | | | | paragraphs [0016]-[0017], [0023], [0043]-[0049] | | | |
| | | | | WO | 2018/210866 | A1 | |
| | | | | EP | 3404126 | A1 | |
| | | | | CN | 110603342 | A | |
| | | | | KR | 10-2020-0010251 | A | |
| WO | 2017/022501 | A1 | 09 February 2017 | US | 2018/0236563 | A1 | |
| | | | | paragraph [0076] | | | |
| | | | | EP | 3332899 | A1 | |
| WO | 2015/186503 | A1 | 10 December 2015 | JP | 2019-69514 | A | |
| | | | | US | 2016/0175939 | A1 | |
| | | | | EP | 3153259 | A1 | |
| | | | | EP | 3363568 | A1 | |
| | | | | CN | 105473261 | A | |
| | | | | KR | 10-2017-0016811 | A | |
| JP | 2018-501408 | A | 18 January 2018 | US | 2018/0223436 | A1 | |
| | | | | US | 2020/0255953 | A1 | |
| | | | | WO | 2016/071104 | A1 | |
| | | | | EP | 3018233 | A1 | |
| | | | | EP | 3215651 | A1 | |
| | | | | KR | 10-2017-0076694 | A | |
| | | | | CN | 107075692 | A | |
| JP | 2015-529571 | A | 08 October 2015 | US | 2015/0211105 | A1 | |
| | | | | WO | 2014/019897 | A1 | |
| | | | | EP | 2880199 | A1 | |
| | | | | DE | 102012107129 | A1 | |
| | | | | CN | 104520472 | A | |
| | | | | KR | 10-2015-0040963 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022045633 A
- JP H797679 A
- JP 2017193004 A
- JP 2015110259 A
- JP 2017018551 A